# EUROPEAN PATENT APPLICATION

(11) **EP 0 919 872 A2**
(43) Date of publication of application: **02.06.1999**
(21) Application number: 98309059.8
(22) Date of filing: 05.11.1998
(51) Int. Cl.: G03F 7/032

(54) **Negative-acting photoimageable compositions comprising unsaturated isocyanate trimers**

(30) Priority: 01.12.1997 US 982199
(71) Applicant: Nichigo Morton Co Ltd, Chuo-ku, Tokyo 104 (JP)
(72) Inventor: Lundy, Daniel E., Placentia, California 92871 (US); Barr, Robert, Laguna Niguel, California 92677 (US)
(74) Representative: Bankes, Stephen Charles Digby

(57) **Abstract**

In a negative acting photoimageable composition comprising an acid functional binder polymer having a weight average molecular weight between 5000 and 40,000, optional additional higher molecular weight binder polymer, photopolymerizable α,β-ethylenically unsaturated compounds, and photoinitiator. At least a portion of the photopolymerizable compounds are isocyanate trimers having tri-α,β-ethylenically unsaturated functionality.

## Description

The present invention is directed to negative-acting photoimageable compositions such as those used as photoresists used to form printed circuit boards. The photoimageable compositions utilize a binder polymer of relatively low molecular weight and contain, as at least a portion of a photopolymerizable component, a photopolymerizable urethane oligomer. This combination results in improved adhesion and processing times, yet flexibility is maintained.

### Background of the Invention

This invention is directed to negative-acting photoimageable compositions which are developable in alkaline aqueous solutions. The invention is particularly applicable to primary photoimaging resists, but is applicable, as well, to compositions that are hardenable so as to form solder masks and the like.

A variety of such photoimageable compositions are described. Essential components of compositions of the type to which the present invention is directed are A) a binder polymer; B) photopolymerizable α,β-ethylenically unsaturated compound(s), and C) a photoinitiator chemical system. The binder polymer A) has sufficient acid functionality, generally carboxylic acid functionality, that it is soluble in alkaline aqueous solution and thereby renders the photoimageable composition developable in alkaline aqueous solutions.

It is generally desirable to shorten processing times of photoresists, whereby greater production volumes are achieved.

Likewise, photoimageable compositions must adhere to a substrate; current formulations are expected to adhere to smoother surfaces and resolve smaller circuit geometries. Thus, improved adhesion is a goal of the present invention.

At the same time, flexibility is a desirable property of photoresists. Printed circuit boards generally have through-holes by which circuitry on one side of the board is connected to circuitry on the other side of the board. Photoresists are required to "tent" these through-holes during processing., Through-holes in printed circuit boards are increasingly becoming larger; accordingly, tenting strength is becoming increasingly important.

Hence, the present invention is directed to photoimageable compositions useful as photoresists having improved adhesion and processing time while retaining good flexibility.

### Summary of the Invention

The negative-acting photoimageable composition comprises A) between about 29 and about 69 wt% based on total weight of A) plus B) plus C) of an organic polymeric binder(s) having sufficient acid functionality to render the photoimageable composition developable in alkaline aqueous solution, the binder polymer or portion of the binder polymer at between about 3 and about 69 wt%, preferably at least about 10 wt%, of the total of A) plus B) plus C) being a polymer A') having a weight average molecular weight between about 5000 and about 40,000, preferably between about 20,000 and about 40,000, balance of the binder polymer, up to about 66 wt%, preferably at least 5 wt%, of of the total of A) plus B) plus C), being a polymer A") having a weight average molecular weight between about 41,000 and about 200,000, B) between about 30 and about 60 wt % (calculated relative to total weight of A) plus B) plus C)) of an addition-polymerizable component, component B) comprising a nongaseous ethylenically unsaturated compound or compounds capable of forming a polymer by free-radical initiated chain-propagating addition polymerization, and between about 0.5 and about 15 wt% of C) (calculated relative to total weight of A) plus B) plus C)) of an organic, radiation-sensitive free-radical generating system activatable by actinic radiation to initiate chain-propagating addition polymerization of the addition-polymerizable material B). Component B) comprises an isocyanate trimer B') having tri-α,β-ethylenically unsaturated functionality, trimer B' comprising between about 2 and about 30 wt% relative to total weight of A) plus B) plus C); balance of B, i.e., up to 57 wt%, preferably at least about 5 wt%, relative to total weight of A) plus B) plus C) of B" comprising other α,β-ethylenically unsaturated monomers. In addition, compositions in accordance with the invention preferably contain between about 1 and about 8 wt%, preferably between about 2 and about 6 wt% (calculated relative to total weight of A) plus B) plus C)) of D) a dibenzoate plasticizer.

### Detailed Description of Certain Preferred Embodiments

Herein, unless otherwise noted, all percentages are weight percentages. Component A) (the binder polymer), Component B) (the photoimageable compounds(s)) and Component C) (the photoinitiator chemical system) are herein considered to equal 100 wt%, and other components, such as plasticizer, are calculated as parts relative to 100 parts of A) plus B) plus C). Molecular weights of polymers and oligomers, unless otherwise stated, are weight average molecular weights.

The invention is directed to photoimageable compositions which are developable in alkaline aqueous solution and which therefore have substantial acid functionality. Such photoimageable compositions typically have a binder polymer A) having acid functionality, typically an acid number of at least about 80, preferably at least about 100 and more preferably about 150 or more, up to about 250. The acid functionality is typically carboxylic acid functionality, but may also include, for example, sulfonic acid functionality or phosphoric acid functionality.

The binder polymer A) is typically derived from a mixture of acid functional monomers and non-acid functional monomers. Some specific examples of suitable acid functional monomers are acrylic acid, methacrylic acid, maleic acid, fumaric acid, citraconic acid, 2-acrylamido-2-methylpropanesulfonic acid, 2-hydroxyethyl acrylolyl phosphate, 2-hydroxypropyl acrylol phosphate, 2-hydroxy-alpha-acryloyl phosphate, etc. One or more of such acid functional monomers may be used to form the binder polymer.

The acid functional monomers may be copolymerized with non-acid functional monomers, such as esters of acrylic acids, for example, methyl acrylate, methyl methacrylate, hydroxy ethyl acrylate, butyl methacrylate, octyl acrylate, 2-ethoxy ethyl methacrylate, t-butyl acrylate, n-butyl acrylate, 2-ethyl hexyl acrylate, n-hexyl acrylate, 1,5-pentanediol diacrylate, N,N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate to provide the desired acid number.

Examples of such polymers and photoimageable compositions using such polymers are found, in the following U.S. Patent Nos: 3,953,309, 4,003,877, 4,610,951, and 4,695,527 the teaching of each of which are incorporated herein by reference.

Binder polymer A') of the photoimageable compositions of the present invention has a weight average molecular weight between about 5000 and about 40,000 preferably at least about 20,000. These molecular weights are relatively low for this type of binder polymer; however, the improved adhesion and processing time of the photoimageable composition of the present invention is largely attributable to the utilization of low molecular weight binder polymer. Binder polymer A') may be used alone, or in admixture with a higher molecular weight binder polymer A"). Higher molecular weight binder polymer A"), if used, is used to enhance tenting strength.

The photoimageable, acrylate functional, isocyanate trimer B') which comprises a portion of, and in some cases all of, the photopolymerizable component B) has the general formula: 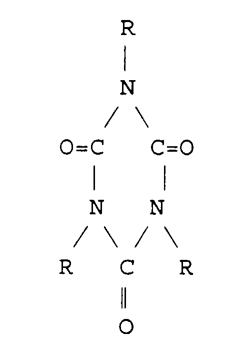 where R is -(CH₂)ₚ-NH-COO-(CHY-CHY-O)ₘ-CO-CX =CH₂, where X is H or CH₃, Y is H, CH₃, or C₂H₅, p is an integer from 1 to 36 and m is an integer from 1 to 14. Such trimers are described in European Patent Application EP 0 738 927 A2.

While the use of low molecular weight binder polymer enhances adhesion and processing time, the short chain polymers tend to reduce overall flexibility of the photoimageable composition. Poor flexibility can cause tented holes to fail and lines to fracture during the many mechanical handling steps, defects which necessitate scrapping printed circuit boards having such defects. The flexibility problem is addressed herein by the use, in conjunction with low molecular weight binder polymers, of the acrylate-functional isocyanate trimer B') (also referred to herein as the "urethane oligomer"). To this end, the molecular weight of the isocyanate trimer should be at least about 1000. The relatively high molecular weight of the urethane oligomer B') compensates for the lower molecular weight of the binder polymer, producing a photoimageable composition with flexibility comparable to those formulations using higher molecular weight polymers.

The balance of photopolymerizable component B), used at 0 to about 30 wt% of the photoimageable composition (calculated relative to total weight of A) plus B) plus C) is B"), typically a monomer, dimer or short chain oligomer having ethylenic unsaturation, particularly α,β-ethylenic unsaturation, including monofunctional compounds and compounds having α,β-ethylenic unsaturation functionality 2 or greater. Typically, a mixture of mono-functional and multi-functional monomers will be used. Suitable photopolymerizable compounds include, but are not limited to, the monomers recited above as suitable for forming binder polymers, particularly the non-acid functional compounds.

To initiate polymerization of the monomers upon exposure to actinic radiation, the photoimageable composition contains photoinitiator chemical system. Suitable photoinitiators include, for example, 9-phenyl acridine, benzoin ethers, benzil ketals, acetophenones, benzophenones and related compounds with amines. Also, suitable 9-phenyl acridine homologues, such as those described in U.S. Patent No. 5,217,845, the teachings of which are incorporated herein by reference, are useful photoinitiators.

As a preferred aspect of the invention, flexibility, is further improved through the use of dibenzoate plasticizers. This combination further contributes to fine line adhesion and good stripping characteristics. Dibenzoate plasticizers in accordance with the invention have the general formula:

C₆H₅-COO-[R]ₙ-R'-C₆H₅ ,

where
R = -CHX-CHX-O- where one or both Xs are H or one X may be CH₃ and the other H; n = 1 to 10, and
R' is -CH₂-CH(CH₃)-OOC-, -CH₂-CH₂-OOC-, or -OC-.
Specific examples of suitable dibenzoates include, but are not limited to dipropyleneglycol dibenzoate, diethylene glycol dibenzoate, polypropyleneglycol dibenzoate, and polyethylene glycol dibenzoate. The dibenzoate plasticizer D), if used, is used at levels of between about 1 and about 8 wt% relative to total weight of A) plus B) plus C), typically at between about 2 and about 6 wt%.

Compared to other plasticizers tested, the dibenzoates produced a significant improvement in tent strength. Coupled with improved flexibility, the combination of dibenzoate plasticizer and the isocyanate trimer produces a fine line (less than 75 microns) resist sidewall that adheres better to the copper surface. It is believed that the addition of the dibenzoate contributes to a lower glass transition temperature (T_{g}) of the formulation. The lower T_{g} allows for better flow at lamination and better conformation to the copper surface. This property is particularly important on copper surfaces with nicks or scratches. Because the composition with the dibenzoate conforms better to the copper, more photoresist surface area is in contact with the copper surface. This results in more potential for chemical bonding to the copper surface and therefore, improved adhesion properties. Because the dibenzoate cannot be incorporated into the backbone of the exposed acrylic monomer system, the inclusion of the dibenzoate compounds results in less overall shrinkage of the composition. This reduced shrinkage probably produces less stress on the copper/photoresist interface, contributing to the improved adhesion. Less shrinkage is particularly observing if 9-phenyl acridine is used as the photoinitiator, as this initiator produces a high degree of cross-link density.

Processing of the photoimageable composition is in a conventional manner. In a typical procedure, a photoimageable composition layer, either formed from a liquid composition or transferred as a layer from a dry film, is applied to a copper surface of a copper-clad board. The photoimageable composition layer is exposed to actinic radiation through appropriate artwork. Exposure to actinic radiation polymerizes the monomer in the light-exposed areas, resulting in a cross-linked structure that is resistant to developer. Next, the composition is developed in dilute alkaline aqueous solution, such as a 1 % sodium carbonate solution. The alkali solution causes salt formation with the carboxylic groups of the binder polymers, rendering them soluble and removable. After development, an etchant may be used to remove copper from those areas where the resist was removed, thereby forming a printed circuit. The remaining resist is then removed using an appropriate stripper.

The invention will now be described in greater detail by way of specific examples.

### Examples A-D (A-C comparative: D in accordance with the invention

Photoimageable compositions A-D are prepared having the following components (Table 1):

**Table 1 -**

| Listing of Photoresist Ingredients (all amounts listed in grams of 100% solid material) | | | | |
|---|---|---|---|---|
| Ingredient | Formula "A" | Formula "B" | Formula "C" | Formula "D" |
| Acrylic Polymer* (MAA 23%, 11% nBA, 66% MMA) | 40 | 40 | 25 | 25 |
| Low Molecular Weight CoPolymer** (35% MAA, 65% Styrene) | - | - | 15 | 15 |
| Urethane Oligomer (RM705) | - | 20 | - | 20 |
| Ethoxylated Trimethylol Propane Triacrylate | 20 | - | 20 | 2 |
| Propylene glycol monomethacrylate | 10 | 10 | 10 | 10 |
| 9-Phenylacridine | 0.20 | 0.20 | 0.20 | 0.20 |
| FlexoBlue 680 | 0.05 | 0.05 | 0.05 | 0.05 |
| Furon Navy | 0.075 | 0.075 | 0.075 | 0.075 |
| Modaflow | 0.10 | 0.10 | 0.10 | 0.10 |
| Hindered Amine Antioxidant | 0.03 | 0.03 | 0.03 | 0.03 |
| Michler's Ethyl Ketone | 0.18 | 0.18 | 0.18 | 0.18 |
| Dipropylene glycol dibenzoate | 3.50 | 3.50 | 3.50 | 3.50 |

| | | | | |
|---|---|---|---|---|
| *M_{w} = 85,000 | | | | |
| **M_{w} = 20,000 MAA = methacrylic acid nBA = n-butyl acrylate MMA = methyl methacrylate | | | | |

All compositions were prepared in 7:1 2-Butanone:2-Propanol at approximately 50% solids. The solutions were coated onto biaxially oriented 80 gauge polyester film and dried to approximately 1% or less retained solvent. The coated mixtures were then laminated onto mechanically scrubbed 1 oz./FR-4/1 oz. clad copper composite using a hot roll laminator at 110°C at 2 meters/minute and 3 bar pressure.

The laminated material was then imaged on a UV printer through an appropriate phototool with an adjusted exposure to obtain a copper step of 7 as measured with a Stouffer® 21 step wedge (approximately 20 mJ/cm²). The exposed panels were then developed in a 1% sodium carbonate monohydrate solution at 29°C using a conveyorized spray developer at about 26 psi with residence time adjusted so that the break point occurred at 40% to 50% of the chamber length (unless otherwise noted in the specific example), followed by several spray rinses using tap water and the deionized water.

Etching was accomplished using a 2N cupric chloride/hydrochloric acid solution at 48°C in a conveyorized etcher equipped with multiple spray nozzles. The etched boards were then stripped of the imaged, developed and etched photo resist in a 3% sodium hydroxide solution at 54°C in a conveyorized stripping unit equipped with mutiple spray nozzles followed by a spray rinse of tap water.

Process responses for the examples are cited at various points throughout the above procedure. Results are shown in Table 2:

**Table 2 -**

| Performance Results (* indicates desired performance) | | | | |
|---|---|---|---|---|
| Testing Parameter | Formula "A" | Formula "B" | Formula "C" | Formula "D" |
| Fine Line Adhesion (minimum line adhered with 400 µ space) | 50 µm | 50 µm | *35 µm | *35 µm |
| Tent Flexibility (grams force to break) | 350 grams | *570 grams | 140 grams | *500 grams |
| Developing Time (1% Na₂CO₃ 30 °C) | 52 seconds | 54 seconds | *38 seconds | *38 seconds |
| Stripping Time (3% NaOH, 50 °C) | 80 seconds | 88 seconds | *52 seconds | *54 seconds |
| Cross Hatch Flexibility (% Resist Intact) | 70 % | *80% | 50% | *75% |
| Note: formula "D" appears to indicate a synergy between the low molecular weight polymer and the urethane oligomer | | | | |

## Claims

1. A photoimageable composition comprising
A) between 29 and 69 wt% of an organic binder polymer(s) having sufficient acid functionality to render said photoimageable composition developable in alkaline aqueous solution, said binder polymer(s) comprising:
A') between 3 and 69 wt% of a binder polymer having a weight average molecular weight between 5000 and 40,000, and
A") 0 to 66 wt% of a binder polymer having a weight average molecular weight between 41,000 and 200,000;
B) between 30 and 60 wt% of an addition polymerizable component comprising one or more α,β-ethylenically unsaturated compounds or compounds capable of forming a polymer by a free-radical initiated chain-propagating addition polymerization, said component (B) comprising
B') an isocyanate trimer having tri-α,β-ethylenically unsaturated functionality, said trimer being present at between 2 to 30 wt%, and
B") 0 to 57 wt% of other α, β-ethylenically unsaturated compounds, and
C) between 0.5 and 15 wt% of an organic, radiation-sensitive free-radical generating system,
all said percentages being based on the total weight of (A) plus (B) plus (C).

2. A photoimageable composition according to Claim 1 wherein component (B") is present in amounts of at least 5 wt% relative to total weight of (A) plus (B) plus (C).

3. A photoimageable composition according to Claim 1 or Claim 2 wherein said free-radical generating system C) comprises 9-phenyl acridine.

4. A photoimageable composition according to any preceding Claim wherein said binder polymer (A') has a weight average molecular weight between 20,000 and 40,000.

5. A photoimageable composition according to any preceding Claim further comprising:
D) between 1 and 8 wt%, calculated relative to total weight of (A) plus (B) plus (C) of a dibenzoate plasticizer.

6. A photoimageable composition according to any preceding Claim wherein said binder polymer (A") is present in an amount of at least 5 wt% relative to total weight of (A) plus (B) plus (C).

7. A photoimageable composition according to any preceding claim wherein the organic binder polymer (A) comprises the lower molecular weight component (A') in an amount of at least 10 wt.% based on the total weight of (A) plus (B) plus (C).

8. A photoimageable composition according to any preceding claim wherein the binder polymer (A) has an acid number of at least 80.

9. A photoimageable composition according to any preceding claim wherein the binder polymer (A) has an acid number from 100 to 250.

10. A photoimageable composition according to any preceding claim wherein the binder polymer (A) is derived from a mixture of acid-functional and non-acid functional monomers.
